# EUROPEAN PATENT APPLICATION

(11) **EP 4 583 155 A1**
(43) Date of publication of application: **09.07.2025**
(21) Application number: 23860413.6
(22) Date of filing: 30.08.2023
(51) Int. Cl.: H01L 21/677

(54) **CERAMIC STRUCTURE**

(30) Priority: 31.08.2022 JP 2022138731
(71) Applicant: Kyocera Corporation, Kyoto-shi, Kyoto 612-8501 (JP)
(72) Inventor: NISHI, Yuuki, Kyoto-shi, Kyoto 612-8501 (JP); KOGA, Junya, Kyoto-shi, Kyoto 612-8501 (JP)
(74) Representative: Viering, Jentschura & Partner mbB Patent- und Rechtsanwälte
(86) International application number: PCT/JP2023/031528
(87) International publication number: WO 2024/048651

(57) **Abstract**

A ceramic structure according to the present disclosure includes a base containing a plurality of ceramic particles. The base includes a base portion including a recessed portion. The recessed portion includes an inner wall surface and a bottom surface. **In** the recessed portion, a porous layer is located at least on a surface portion of the inner wall surface, and when an average value of thicknesses of the porous layer on the inner wall surface is defined as a first thickness, and a thickness of the porous layer on the bottom surface is defined as a second thickness, the second thickness is smaller than the first thickness.

## Description

### TECHNICAL FIELD

The present disclosure relates to a ceramic structure.

### BACKGROUND OF INVENTION

Patent Document 1 discloses a ceramic transfer arm including an adsorption hole for adsorbing a transfer object such as a semiconductor wafer, a suction hole connected to a suction mechanism, and a suction path through which the adsorption hole and the suction hole communicate with each other.

### CITATION LIST

### PATENT LITERATURE

Patent Document 1: JP 2018-125374 A

### SUMMARY

A ceramic structure according to one aspect of the present disclosure includes a base containing a plurality of ceramic particles. The base includes a base portion including a recessed portion. The recessed portion includes an inner wall surface and a bottom surface. In the recessed portion, a porous layer is located at least on a surface portion of the inner wall surface, and when an average value of thicknesses of the porous layer on the inner wall surface is defined as a first thickness, and a thickness of the porous layer on the bottom surface is defined as a second thickness, the second thickness is smaller than the first thickness.

### ADVANTAGEOUS EFFECT

According to the present disclosure, for example, heat transfer between a fluid in a recessed portion and a base can be reduced, while a strength of the base is maintained.

### BRIEF DESCRIPTION OF THE DRAWINGS

FIG. 1 is a plan view illustrating an example of a ceramic structure as a transfer arm.
FIG. 2 is a cross-sectional view taken along arrows II-II in FIG. 1.
FIG. 3 is a cross-sectional view taken along arrows III-III in FIG. 2.
FIG. 4 is a cross-sectional view taken along arrows IV-IV in FIG. 3.
FIG. 5 is a cross-sectional view of a first base of the ceramic structure according to another embodiment.

### DESCRIPTION OF EMBODIMENTS

Modes (hereinafter, referred to as "embodiments") for implementing a ceramic structure according to the present disclosure will be described in detail below with reference to the accompanying drawings. Note that the present disclosure is not limited by the embodiments. Embodiments can be appropriately combined so as not to contradict each other in terms of processing content. In the following embodiments, the same portions are denoted by the same reference signs, and redundant explanations are omitted.

In the following embodiments, expressions such as "constant", "orthogonal", "perpendicular", and "parallel" may be used, but these expressions need not mean exactly "constant", "orthogonal", "perpendicular", and "parallel". In other words, each of the expressions described above allows for deviations in, for example, manufacturing accuracy, or installation accuracy.

In each of the drawings, which will be referred to below, for ease of explanation, an X axis direction, a Y axis direction, and a Z axis direction that are orthogonal to each other may be defined to illustrate a rectangular coordinate system in which a Z axis positive direction is a vertically upward direction. A rotation direction about the vertical axis as a rotation center may be referred to as a θ direction.

Conventionally, a transfer arm has been used to transfer a sample such as a semiconductor wafer. Patent Document 1 discloses a transfer arm in which a body made of ceramics includes an adsorption hole for adsorbing a transfer object and a suction hole connected to a suction mechanism, and a suction path, through which the adsorption hole and the suction hole communicate with each other, is provided inside the body.

A body of the transfer arm disclosed in Patent Document 1 is made of ceramics. Thus, the transfer arm has a high corrosion resistance and a high strength. However, in the transfer arm described in Patent Document 1, when the temperature of a fluid in the suction path is high, a thermal stress is generated in the body due to a temperature difference between the fluid and the body portion, and separation or cracking may occur.

Thus, a technique for reducing the heat transfer between the fluid in the recessed portion and the base while maintaining the strength of the base is anticipated.

Hereinafter, an example in which the ceramic structure according to the embodiment is applied to a transfer arm for transferring a sample such as a semiconductor wafer will be described. The ceramic structure according to the embodiment is applicable to other devices than the transfer arm. For example, the ceramic structure according to the embodiment may be applied to a shower plate that ejects heated process gas to the sample such as the semiconductor wafer. The shower plate in this case may include, for example, a disk-shaped base made of ceramics, a channel formed inside the base, and a resistance heating element buried in the base. Other than that, the ceramic structure according to the embodiment may be applied to, for example, a heat exchanger.

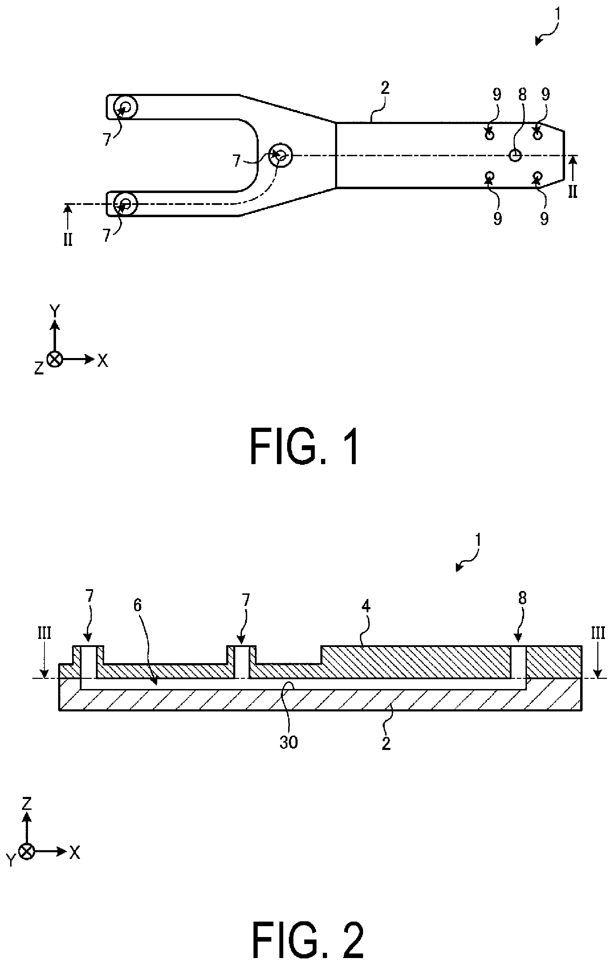

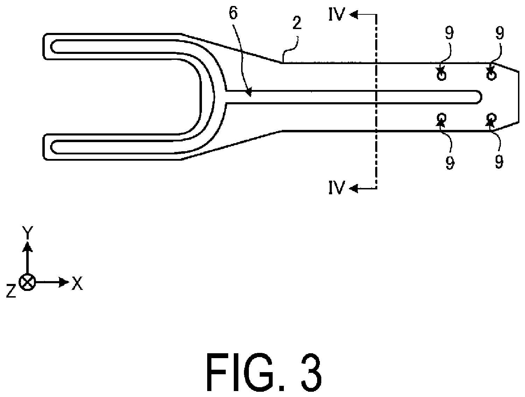

First, a configuration of a ceramic structure 1 as a transfer arm will be described with reference to FIGs. 1 to 3. FIG. 1 is a plan view illustrating an example of the ceramic structure 1 as the transfer arm. FIG. 2 is a cross-sectional view taken along arrows II-II in FIG. 1. FIG. 3 is a cross-sectional view taken along arrows III-III in FIG. 2.

As illustrated in FIG. 1, the ceramic structure 1 as the transfer arm may have a Y-shape in a plan view. Specifically, the ceramic structure 1 may include a linearly extending arm portion and a bifurcated holding portion provided at a tip end of the arm portion. The ceramic structure 1 may include a plurality of (three in the drawing) intake ports 7 at a base end portion and bifurcated tip end portions of the holding portion. The ceramic structure 1 may include an exhaust port 8 at a base end portion of the arm portion. Further, the ceramic structure 1 may include a plurality of through holes 9 for connecting the ceramic structure 1 to a shaft or the like of a transfer device (not illustrated) with bolts.

In the illustrated example, the ceramic structure 1 has the Y-shape in a plan view. However, the shape of the ceramic structure 1 is not limited to the Y-shape, and may be a rectangular shape, a circular shape, a trapezoidal shape, or other shape. In the illustrated example, the ceramic structure 1 includes three intake ports 7; however, the number of intake ports 7 is not limited to three.

As illustrated in FIG. 2, a channel 6 connecting to the plurality of intake ports 7 and the exhaust port 8 described above may be located inside the ceramic structure 1. When a suction mechanism (not illustrated) connected to an opening portion of the exhaust port 8 is operated, by using an adsorption force generated at this time, the ceramic structure 1 can adsorb a sample.

The ceramic structure 1 may include a first base 2 and a second base 4. A recessed portion 30 described later may be located on a surface of the first base 2. The recessed portion 30 may extend along a first direction (here, for example, the X-axis direction) and form a part of the channel 6. The second base 4 may include the plurality of intake ports 7 and the exhaust port 8 described above. The plurality of intake ports 7 and the exhaust port 8 may penetrate through the second base 4.

The second base 4 is located on the first base 2 so as to close a surface of the first base 2 on which the recessed portion 30 is located. The first base 2 and the second base 4 are bonded to each other via, for example, an adhesive. When the first base 2 and the second base 4 are bonded to each other, an opening portion of the recessed portion 30 is closed by the second base 4. This forms the channel 6 described above. The second base 4 is an example of a cover portion.

The first base 2 and the second base 4 may contain a plurality of ceramic particles. The ceramic particles may be, for example, particles of silicon carbide (SiC). Examples of other ceramic particles include alumina, zirconia, and silicon nitride. When the ceramic particles are silicon carbide, the first base 2 and the second base 4 are suitable for electric discharge machining described later.

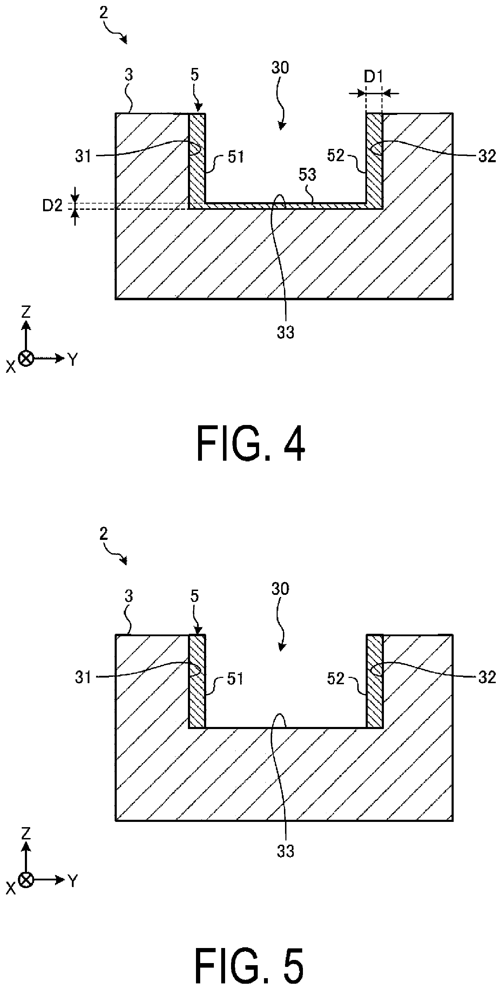

The first base 2 and the second base 4 may further contain a metal phase. The metal phase may be, for example, silicon (Si). When the metal phase is contained, the first base 2 and the second base 4 are suitable for the electric discharge machining even if the ceramic particles do not have electrical conductivity. When silicon carbide is used as the ceramic particles and Si is contained as the metal phase, the first base 2 and the second base 4 are particularly suitable for the electric discharge machining. In the case of a combination of silicon carbide and Si, silicon carbide may be from 60 vol% to 95 vol%, and Si may be from 5 vol% to 40 vol%. The base may be produced by preparing a powder compact by using raw materials having such a ratio and firing the powder compact at 1400°C to 1500°C in a non-oxidizing atmosphere. The first base 2 and the second base 4 may further contain oxygen. The detailed configuration of the first base 2 will be described below with reference to FIG. 4.

Next, a configuration of the first base 2 of the ceramic structure 1 according to the embodiment will be described with reference to FIG. 4. FIG. 4 is a cross-sectional view taken along arrows IV-IV in FIG. 3. As illustrated in FIG. 4, the first base 2 may include a base portion 3 including the recessed portion 30 and a porous layer 5 located on a surface of the recessed portion 30.

The recessed portion 30 may include a first wall surface 31 (an example of an inner wall surface), a second wall surface 32 (an example of an inner wall surface) located to face the first wall surface 31, and a bottom surface 33.

The base portion 3 may be dense. The porous layer 5 includes gaps. The gap is a region where the ceramic particles and the metal phase are not present in the porous layer 5. The amount of gaps in the porous layer 5 may be larger than that in the base portion 3. When the base portion 3 includes voids, the size of the gap may be larger than the size of the void in the base portion 3. The size of the gap may be from 0.5 µm to 50 µm in terms of equivalent circle diameter. When the size of the gap is large, the coefficient of thermal conductivity of the porous layer 5 is small. When the size of the gap is small, the strength of the porous layer 5 is less degraded. When the size of the gap is from about 3 µm to 20 µm, the thermal conduction and the strength are well-balanced. Note that the sizes of the gap and the void described below are equivalent circle diameters. Porosity of the porous layer 5 may be 5 vol% or more and 20 vol% or less. When the porous layer 5 is located on a surface portion of the recessed portion 30, heat transfer between a fluid (for example, gas) flowing through the channel 6 and the first base 2 can be reduced. The porosity described herein can be obtained from a cross-sectional photograph of the porous layer 5. An area ratio of pores in the porous layer 5 in the cross-sectional photograph is referred to as the porosity. A magnification of the cross-sectional photograph may be, for example, from 100 times to 10000 times. The magnification at the time of photographing may be set to such a magnification that a shape of the pore can be determined. A specific measurement of the porosity may be performed by importing a photograph taken into image analysis software, binarizing the photograph, and distinguishing the pores from the other portions.

The porous layer 5 may be located on, for example, each of the first wall surface 31, the second wall surface 32, and the bottom surface 33. Hereinafter, the porous layer 5 located on the first wall surface 31 is referred to as "first porous layer 51", the porous layer 5 located on the second wall surface 32 is referred to as "second porous layer 52", and the porous layer 5 located on the bottom surface 33 is referred to as "third porous layer 53".

Here, an average value of the thicknesses of the first porous layer 51 and the second porous layer 52 is referred to as "first thickness D1". In addition, a thickness of the third porous layer 53 is referred to as "second thickness D2". In this case, the second thickness D2 may be smaller than the first thickness D1. The first thickness D1 may be, for example, from 3 µm to 200 µm. The second thickness D2 may be smaller than the first thickness D1 and may be, for example, from 0 µm to 50 µm. As the first thickness D1 is greater, heat transfer via the first porous layer 51 is reduced. The first thickness D1 may be 3 µm or more. In particular, the first thickness D1 is preferably 10 µm or more, and 50 µm or more. The first thickness D1 may be 200 µm or less. The second thickness D2 may be 0 µm. In particular, the second thickness D2 is preferably 3 µm or less. For example, the second thickness D2 may be 30% or less of the first thickness D1.

The porous layer 5 includes the gaps, and thus the strength of the porous layer 5 is lower than that of the base portion 3. In addition, the bottom surface 33 of the recessed portion 30 is more likely to be a starting point of breakage compared to the first wall surface 31 and the second wall surface 32. On the other hand, in the ceramic structure 1 according to the embodiment, the second thickness D2 is smaller than the first thickness D1, and thus the breakage which starts from the bottom surface 33 is less likely to occur compared to the case where the second thickness D2 is equal to the first thickness D1. Thus, the ceramic structure 1 according to the embodiment can reduce the heat transfer between the fluid flowing through the channel 6 and the first base 2 while maintaining the strength of the ceramic structure 1.

The porous layer 5 may contain oxygen. For example, oxygen in the porous layer 5 may be bonded to a metal element in the porous layer 5 to form an oxide. A content of oxygen in the porous layer 5 may be larger than a content of oxygen in the base portion 3. In this case, the porous layer 5 is less likely to be oxidized compared to the base portion 3, and thus is less likely to be altered. A large amount of oxygen may be distributed on a surface of the porous layer 5.

The porous layer 5 may contain a metal phase. The metal phase may be, for example, silicon (Si). A content of the metal phase in the base portion 3 may be larger than a content of the metal phase in the porous layer 5. **In** this case, the base portion 3 has higher resistance to tensile stress compared to the porous layer 5, and separation or cracking is less likely to occur.

Next, an example of a manufacturing method for the first base 2 of the ceramic structure 1 according to the embodiment will be described. First, green sheets are formed by a doctor blade method or a roll compaction method using raw material of the first base 2. Then, a plurality of the green sheets are layered to obtain a layered body. Subsequently, the obtained layered body is fired to obtain a sintered body of the first base 2.

Subsequently, the sintered body of the first base 2 is subjected to the electric discharge machining to form the recessed portion 30 in which the porous layer 5 is located on the surface portion. For example, the sintered body of the first base 2 is subjected to the electric discharge machining to form the porous layer 5 on the first wall surface 31, the second wall surface 32, and the bottom surface 33 of the recessed portion 30. Thereafter, the sintered body of the first base 2 is subjected to blasting to remove a part of the porous layer 5 on the bottom surface 33, so that the first base 2 according to the embodiment can be obtained. The recessed portion 30 can also be produced by subjecting the sintered body of the first base 2 to grinding and blasting, then to the electric discharge machining, and further to the blasting.

Note that the method of obtaining the first base 2 is not limited to the method described above. For example, the layered body may be subjected to machining to form the recessed portion 30, and then fired to obtain the first base 2. **In** this case, the porous layer 5 is not present on the surface of the recessed portion 30, and thus the surface of the recessed portion 30 may be subjected to the electric discharge machining to form the porous layer 50, and then the thickness of the porous layer 50 on the bottom surface 33 may be reduced by the blasting or other method.

The formation of the recessed portion 30 by the electric discharge machining can be performed by using a commercially available electric discharge machine such that the sintered body of the first base 2 is immersed in a cooling machining liquid such as kerosene or deionized water, a high-frequency pulse voltage is applied to an engraving machining electrode to generate arc discharge between the electrode and the sintered body facing the electrode, and a portion to serve as the recessed portion 30 is melted and removed. The above-described machining electrode may be made of a copper-tungsten alloy, a silver-tungsten alloy, copper, brass, graphite, copper-graphite, or the like. Machining of the recessed portion 30 can be performed with high precision by spacing the electrode apart from a machining location to face the machining location with a distance of 1 µm to several tens of µms and applying a no-load voltage from 90 V to 300 V. The blasting can be performed by masking a portion other than the recessed portion 30, then feeding an abrasive made of material such as glass, alumina, GC, or B₄C into a commercially available blasting machine, and projecting the abrasive toward the bottom surface of the recessed portion 30.

As described above, the ceramic structure (as an example, the ceramic structure 1) according to the embodiment includes the base (as an example, the first base 2) containing the plurality of ceramic particles. The base includes the base portion (as an example, the base portion 3) including the recessed portion (as an example, the recessed portion 30). The recessed portion includes the inner wall surfaces (as an example, the first wall surface 31 and the second wall surface 32) and the bottom surface (as an example, the bottom surface 33). In the recessed portion, the porous layer (as an example, the first porous layer 51 and the second porous layer 52) is located at least on the surface portion of the inner wall surface, and when the average value of the thicknesses of the porous layer on the inner wall surface is defined as a first thickness, and a thickness of the porous layer on the bottom surface is defined as a second thickness, the second thickness is smaller than the first thickness.

In the ceramic structure 1 according to the embodiment, the porous layer 5 is located at least on the surface portions of the first wall surface 31 and the second wall surface 32, and thus heat transfer between the fluid (for example, gas) flowing through the channel and the base can be reduced.

In the ceramic structure 1 according to the embodiment, the thickness of the porous layer 5 (the third porous layer 53) on the bottom surface 33 is smaller than the thickness of the porous layer 5 (the first porous layer 51 and the second porous layer 52) on the first wall surface 31 and the second wall surface 32. According to such a configuration, the porous layer 5 is thinner on the bottom surface 33, which has a high probability of becoming the starting point of breakage, compared to on the first wall surface 31 and the second wall surface 32. Thus, the breakage which starts from the bottom surface 33 is less likely to occur, and the strength can be maintained.

Thus, the ceramic structure 1 according to the embodiment can reduce the heat transfer between the fluid in the recessed portion 30 and the base, while maintaining the strength of the ceramic structure 1.

### Other Embodiments

In the embodiment described above, the example has been described with reference to FIG. 4 in which the second thickness D2 is smaller than the first thickness D1. The second thickness D2 is not limited to the example of FIG. 4. The second thickness D2 may be 0% of the first thickness D1. That is, the porous layer 5 may not be located on the bottom surface 33.

FIG. 5 is a cross-sectional view of the first base 2 of the ceramic structure 1 according to another embodiment. As illustrated in FIG. 5, the ceramic structure 1 according to the embodiment may include the porous layer 5 (the first porous layer 51 and the second porous layer 52) on the surface portions of the first wall surface 31 and the second wall surface 32, and need not include the porous layer 5 (the third porous layer 53) on the bottom surface 33. According to such a configuration, the breakage which starts from the bottom surface 33 is less likely to occur compared to a case where the porous layer 5 is present on the bottom surface 33, and the strength can be maintained.

Note that the embodiments disclosed herein are exemplary in all respects and not restrictive. The aforementioned embodiments can be embodied in a variety of forms. The above-described embodiments may be omitted, substituted or modified in various forms without departing from the scope and spirit of the appended claims.

### REFERENCE SIGNS

1 Ceramic structure
2 First base
3 Base portion
5 Porous layer
30 Recessed portion
31 First wall surface (example of inner wall surface)
32 Second wall surface (example of inner wall surface)
33 Bottom surface
51 First porous layer
52 Second porous layer
53 Third porous layer

## Claims

1. A ceramic structure comprising:
a base containing a plurality of ceramic particles, wherein
the base comprises a base portion comprising a recessed portion,
the recessed portion comprises an inner wall surface and a bottom surface,
a porous layer is located at least on a surface portion of the inner wall surface, and
when an average value of thicknesses of the porous layer on the inner wall surface is defined as a first thickness, and a thickness of the porous layer on the bottom surface is defined as a second thickness, the second thickness is smaller than the first thickness.

2. The ceramic structure according to claim 1, wherein porosity of the porous layer is 5 vol% or more and 20 vol% or less.

3. The ceramic structure according to claim 1, wherein
the first thickness is 10 µm or more, and
the second thickness is 3 µm or less.

4. The ceramic structure according to claim 1, wherein
the base contains a metal phase, and
a content of the metal phase in the base portion is larger than a content of the metal phase in the porous layer.

5. The ceramic structure according to claim 1, wherein
the base contains oxygen, and
a content of oxygen in the porous layer is larger than a content of oxygen in the base portion.

6. The ceramic structure according to claim 4, wherein
the ceramic particles are SiC particles, and
the metal phase is Si.

7. The ceramic structure according to claim 1, wherein the recessed portion is a channel extending in a first direction.

8. The ceramic structure according to claim 1, further comprising a cover portion covering the recessed portion.
